(19) Europäisches Patentamt
European Patent Office
Office européen des brevets

(11) **EP 3 789 777 B1**

(12) **EUROPEAN PATENT SPECIFICATION**

(45) Date of publication and mention
of the grant of the patent:
**21.09.2022 Bulletin 2022/38**

(21) Application number: **20757507.7**

(22) Date of filing: **19.06.2020**

(51) International Patent Classification (IPC):
**G01R 31/62** (2020.01)     **H01F 27/40** (2006.01)
**H02H 7/055** (2006.01)

(52) Cooperative Patent Classification (CPC):
**G01R 31/62; H01F 27/402; H02H 7/055**

(86) International application number:
**PCT/CN2020/097219**

(87) International publication number:
**WO 2020/259415 (30.12.2020 Gazette 2020/53)**

(54) **TRANSFORMER MONITORING METHOD AND DEVICE AND STORAGE MEDIUM**

VERFAHREN UND VORRICHTUNG ZUR ÜBERWACHUNG EINES TRANSFORMATORS UND SPEICHERMEDIUM

PROCÉDÉ ET DISPOSITIF DE SURVEILLANCE DE TRANSFORMATEUR ET SUPPORT D'INFORMATIONS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.06.2019 CN 201910565853**

(43) Date of publication of application:
**10.03.2021 Bulletin 2021/10**

(73) Proprietor: **Shandong Electrical Engineering & Equipment Group Intelligent Electric Co., Ltd Jinan, Shandong 250000 (CN)**

(72) Inventors:
• **ZHANG, Miao**
  **Beijing 100075 (CN)**
• **WEI, Caixia**
  **Jinan, Shandong 250022 (CN)**
• **SUN, Jerong**
  **Jinan, Shandong 250022 (CN)**
• **QIAO, Chunlai**
  **Jinan, Shandong 250022 (CN)**
• **CHEN, Fei**
  **Jinan, Shandong 250022 (CN)**
• **QI, Yunlong**
  **Jinan, Shandong 250022 (CN)**
• **LI, Xixun**
  **Jinan, Shandong 250022 (CN)**
• **PAN, Fei**
  **Jinan, Shandong 250022 (CN)**
• **GUO, Yingying**
  **Jinan, Shandong 250022 (CN)**
• **ZHOU, Xinlin**
  **Jinan, Shandong 250022 (CN)**

(74) Representative: **White, Andrew John et al Mathys & Squire The Shard 32 London Bridge Street London SE1 9SG (GB)**

(56) References cited:
| | |
|---|---|
| EP-A1- 2 730 929 | WO-A2-2008/057810 |
| CN-A- 1 484 034 | CN-A- 101 256 211 |
| CN-A- 106 443 275 | CN-A- 110 196 370 |
| CN-U- 201 740 828 | CN-Y- 2 366 856 |
| CN-Y- 201 331 560 | JP-A- H05 227 644 |
| US-A1- 2017 011 612 | US-A1- 2017 030 958 |

**Description**

CROSS-REFERENCE TO RELATED APPLICATION

This application is based upon and claims priority to Chinese Patent Application No. 201910565853.2, filed on June 26, 2019.

TECHNICAL FIELD

The application relates to the technical field of transformers, and more particularly, to a method and apparatus for monitoring a transformer, and a storage medium.

BACKGROUND

An oil-immersed distribution transformer may be applied to a pole-mounted distribution area, an American box-type transformer substation, an European box-type transformer substation, a power distribution room and other places. For the existing oil-immersed distribution transformer, when operation parameters of the transformer are calculated, voltage and current parameters on the high-voltage or low-voltage side are required to be collected at the same time. An expensive voltage transformer is used necessarily on the 10 kV high-voltage side of the existing transformer, but the existing high-voltage transformer is immature in application and is insufficient in operation stability, and therefore defects exist in actual use.

Related technologies are known from EP 2730929 A1, WO 2008/057810 A2 and US 2017/030958 A1.

SUMMARY

An objective of the application is to provide a method for monitoring a digital oil-immersed distribution transformer, to relieve the problems of abnormal monitoring and high monitoring cost due to the fact that, when operation parameters of the transformer are calculated and a state of the transformer is monitored, an immature high-voltage transformer is used necessarily on a high-voltage side in the conventional art.

The features of the method for monitoring a transformer and apparatus, and the storage medium according to the present disclosure are defined in the independent claims, and the preferable features according to the present invention are defined in the dependent claims.

According to the method for monitoring the transformer provided by the application, the basic parameters of the transformer in the current operation state are collected, the basic parameters including the winding temperature, the current at the low-voltage side, the voltage at the low-voltage side and the current at the high-voltage side; the operation parameters of the transformer are calculated according to the basic parameters, the operation parameters at least including: the current tap position information of the transformer, the voltage information on the high-voltage side of the transformer and the three-phase load unbalance rate information on the low-voltage side; and if it is monitored that the at least one parameter value of the operation parameters exceeds the corresponding predetermined range, the alarm information is sent.

By calculating the voltage information on the high-voltage side, the use of a high-voltage transformer is avoided, the cost and the monitoring qualification rate of the device are guaranteed to the greatest extent while the monitoring precision is guaranteed, and an alarm may be sent timely in case of abnormity and failure of the device to prevent the loss caused by shutdown of the transformer.

The apparatus for monitoring the transformer disclosed by the application may also achieve the above technical effects.

BRIEF DESCRIPTION OF THE DRAWINGS

In order to describe the technical solutions in the specific implementations of the application or in the conventional art more clearly, a simple introduction on the accompanying drawings which are needed in the description of the specific implementation manners or the conventional art is given below. Apparently, the accompanying drawings in the description below are merely some of the embodiments of the application, based on which other drawings may be obtained by those of ordinary skill in the art without any creative effort.

FIG. 1 is a flow chart of a method for monitoring a transformer provided by an embodiment of the application.

FIG. 2 is a positive sequence circuit diagram of a transformer provided by an embodiment of the application.

FIG. 3 is a negative sequence circuit diagram of a transformer provided by an embodiment of the application.

FIG. 4 is a zero sequence circuit diagram of a transformer provided by an embodiment of the application.

FIG. 5 is a flow chart of a method for monitoring a transformer provided by another embodiment of the application.

FIG. 6 is a structure diagram of an apparatus for monitoring a transformer provided by an embodiment of the application.

FIG. 7 is a structure diagram of an apparatus for monitoring a transformer provided by another embodiment of the application.

In the figures: 100-data collection module; 200-parameter calculation module; 300-monitoring alarm module; and 400-remote control module.

FIG. 8 is a structure diagram of a hardware composition of an apparatus for monitoring a transformer provided by an embodiment of the application.

DETAILED DESCRIPTION

The technical solutions of the application are described below clearly and completely in combination with the embodiments. Apparently, the described embodiments are a part, rather than all, of the embodiments of the application. All other embodiments obtained by those skilled in the art based on the embodiments of the application without creative efforts shall fall within the protection scope of the application.

Embodiment 1

The technical problem to be solved by the embodiment lies in: for the existing oil-immersed distribution transformer, when operation parameters of the transformer are calculated, voltage and current parameters on the high-voltage or low-voltage side are required to be collected at the same time. An expensive voltage transformer is used necessarily on the 10 kV high-voltage side of the existing transformer, but the existing high-voltage transformer is immature in application and is insufficient in operation stability, and therefore defects exist in actual use. Moreover, the existing apparatus for monitoring the oil-immersed distribution transformer cannot completely master the operation state of the transformer.

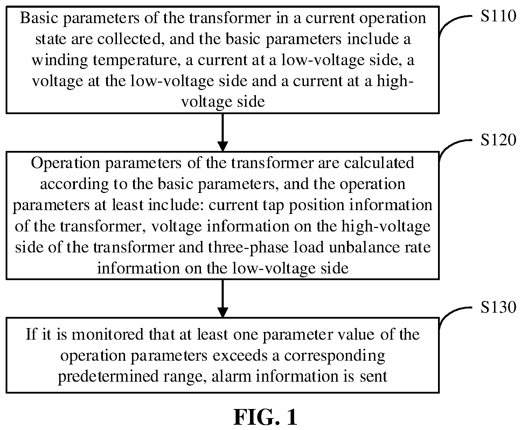

As illustrated in FIG. 1, a method for monitoring a transformer provided by the embodiment may include the following operations.

At S110: basic parameters of the transformer in a current operation state are collected, and the basic parameters include a winding temperature, a current at/on a low-voltage side, a voltage at the low-voltage side and a current at a high-voltage side.

At S120: operation parameters of the transformer are calculated according to the basic parameters, and the operation parameters at least include: current tap position information of the transformer, voltage information on the high-voltage side of the transformer and three-phase load unbalance rate information on the low-voltage side.

In some embodiments, according to a carried load and a monitored oil surface temperature, a real-time temperature rise calculation procedure is used to calculate an average temperature and a hot-spot temperature for high and low windings, thereby determining whether the transformer may run continuously.

The determination condition for determining whether the transformer may run continuously may be as follow.

When a load rate is 1.5 and the load pertains to a normal periodic load, a winding hot-spot temperature should be less than or equal to 120°C, and the temperature of top oil should be less than than or equal to 105°C.

When the load rate is 1.8 and the load pertains to a long-term emergency load, the winding hot-spot temperature should be less than than or equal to 140°C, and the temperature of top oil should be less than than or equal to 115°C.

When the load rate is 2.0, the transformer is not allowed to run continuously.

At S130, if it is monitored that at least one parameter value of the operation parameters exceeds a corresponding predetermined range, alarm information is sent.

By calculating the voltage information on the high-voltage side, the use of a high-voltage transformer is avoided, the cost and the monitoring qualification rate of the device are guaranteed to the greatest extent while the monitoring precision is guaranteed, and an alarm may be sent timely in case of abnormity and failure of the device to prevent the loss caused by shutdown of the transformer.

Embodiment 2

The technical problem to be solved by the embodiment lies in: for the existing oil-immersed distribution transformer, when operation parameters of the transformer are calculated, voltage and current parameters on the high-voltage or low-voltage side are required to be collected at the same time. An expensive voltage transformer is used necessarily on the 10 kV high-voltage side of the existing transformer, but the existing high-voltage transformer is immature in application and is insufficient in operation stability, and therefore defects exist in actual use. Moreover, the existing apparatus for monitoring the oil-immersed distribution transformer cannot completely master the operation state of the transformer.

A method for monitoring a transformer is provided by the embodiment, and may include the following operations.

At S110: basic parameters of the transformer in a current operation state are collected, and the basic parameters include a winding temperature, a current at a low-voltage side, a voltage at the low-voltage side and a current at a high-voltage side.

At S120: operation parameters of the transformer are calculated according to the basic parameters, and the operation parameters at least include: current tap position information of the transformer, voltage information on the high-voltage side of the transformer and three-phase load unbalance rate information on the low-voltage side.

A tap changer position is calculated according to the current at the high-voltage side, the current at the low-voltage side and a known theoretical variation ratio $k_n$.

If $\left| \dfrac{I_1}{I_2} - k_n \right| / k_n < 1.25\%$ is met, it is determined that the tap changer position is n.

A dynamic phase splitting line impedance of the transformer is calculated according to a phase splitting positive sequence line impedance at a premeasured winding temperature $\tau_0$ of the transformer, and an average winding temperature $\tau_1$.

The phase splitting positive sequence line impedance at the premeasured winding temperature $\tau_0$ of the transformer is: $\left( \overline{Z_{1A}} + \overline{Z'_{2A}} \right) = R_A + jX_A$ , $\left( \overline{Z_{1B}} + \overline{Z'_{2B}} \right) = R_B + jX_B$ and $\left( \overline{Z_{1C}} + \overline{Z'_{2C}} \right) = R_C + jX_C$ .

A coefficient for the average winding temperature $\tau_1$ is:

$k_t = (235+\tau_1)/(235+\tau_0)$, where a value of the $k_t$ is a temperature coefficient.

A dynamic phase splitting positive sequence line impedance at the average winding temperature $\tau_1$ is:

$$\left( \overline{Z_{1A}} + \overline{Z'_{2A}} \right) = k_t \times R_A + jX_A \quad , \quad \left( \overline{Z_{1A}} + \overline{Z'_{2A}} \right) = k_t \times R_A + jX_A \quad , \quad \text{and}$$

$$\left( \overline{Z_{1C}} + \overline{Z'_{2C}} \right) = k_t \times R_C + jX_C \quad ,$$

where, the $\left( \overline{Z_{1A}} + \overline{Z'_{2A}} \right)$ is converted to a positive sequence line impedance at the high-voltage side; a negative sequence line impedance of the transformer is equal to the positive sequence line impedance of the transformer; a zero sequence impedance of the transformer is a measured value; in case of Dy connection, then it is $\left( \overline{Z_{1A}} // \overline{Z_m^0} + \overline{Z'_{2A}} \right)$

; and in case of Yy connection, then it is $\left( \overline{Z_m^0} + \overline{Z'_{2A}} \right)$ .

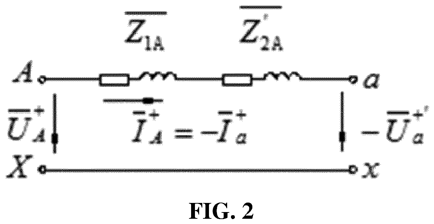

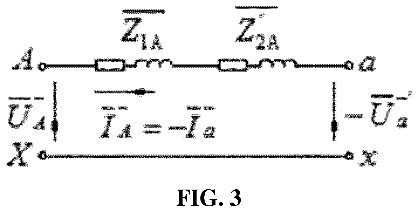

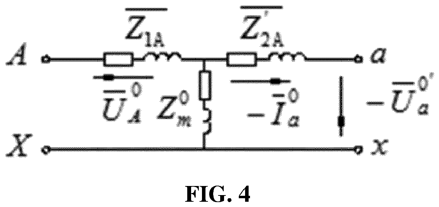

Through the voltage at the low-voltage side of the transformer and the current at the low-voltage side, a three-phase positive sequence voltage, a three-phase negative sequence voltage and a three-phase zero sequence voltage at the high-voltage side, as well as a three-phase positive sequence current, a three-phase negative sequence current and a three-phase zero sequence current at the high-voltage side are obtained in terms of a symmetrical component method. As illustrated in FIGs. 2, 3, and 4, in case of an A-phase circuit:

the three-phase positive sequence voltage converted from the low-voltage side to the high-voltage side is:

$-\overline{U}_a^{+'} = k_n \times \left( -\overline{U}_a^+ \right)$ ; the three-phase negative sequence voltage converted from the low-voltage side to the high-voltage side is: $-\overline{U}_a^{-'} = k_n \times \left( -\overline{U}_a^- \right)$ ; and the three-phase zero sequence voltage converted from the low-voltage side to the high-voltage side is: $-\overline{U}_a^{0'} = k_n \times \left(-\overline{U}_a^0\right)$ .

Where, the $k_n$ is a theoretical variation ratio at an n tap position, $-\overline{U}_a^+$ is the voltage at the low-voltage side, and the $-\overline{U}_a^+$, the $-\overline{U}_a^+$ and the $-\overline{U}_a^0$ are positive, negative and zero sequence voltages at the low-voltage side.

The positive sequence current at the high-voltage side is: $\overline{I}_A^+ = -\overline{I}_a^+$ ; the negative sequence current at the high-voltage side is: $\overline{I}_A^- = -\overline{I}_a^-$ ; and the zero sequence current at the high-voltage side is: $\overline{I}_A^0 = -\overline{I}_a^0$ (when the high-voltage is in D-shaped connection), where the $-\overline{I}_a^+$, the $-\overline{I}_a^-$ and the $-\overline{I}_a^0$ are currents converted from the low-voltage side to the high-voltage side.

The voltage at the high-voltage side is calculated according to the dynamic phase splitting line impedance of the transformer as well as the three-phase positive sequence voltage/current, negative sequence voltage/current and zero sequence voltage/current at the low-voltage side.

In case of the A-phase circuit, $\overline{U}_A = \overline{U}_A^+ + \overline{U}_A^- + \overline{U}_A^0$ .

Where, $\overline{U}_A^+ = -\overline{U}_a^{+'} + \overline{I}_A^+ \times \left(\overline{Z_{1A}} + \overline{Z_{2A}'}\right)$ , $\overline{U}_A^- = -\overline{U}_a^{-'} + \overline{I}_A^- \times \left(\overline{Z_{1A}} + \overline{Z_{2A}'}\right)$ and $\overline{U}_A^0 = \overline{I}_A^0 \times \overline{Z_{1A}}$

(when the high-voltage side of the transformer is in D connection, the zero sequence current $\overline{I_A^0}$ exists; and when it is in star-like connection, no zero sequence current $\overline{I_A^0}$ exists).

A three-phase load unbalance rate at the low-voltage side is: a difference between a maximum phase load and a minimum phase load is divided by the maximum phase load and is multiplied by 100%, that is, (a maximum phase load-a minimum phase load)/the maximum phase load*100%.

At S130: if it is monitored that at least one parameter value of the operation parameters exceeds a corresponding predetermined range, alarm information is sent.

A ratio k of an average three-phase voltage value of the transformer to a rated voltage at the low-voltage side is calculated, and in case of $(K-K_n)/K_n > 2.5\%$, it is determined that a tap position of the transformer needs to be adjusted, and a tap position to be adjusted is given.

A voltage deviation value of the transformer is calculated, and if the voltage deviation value of the transformer exceeds 7%, it is determined that the voltage at the high-voltage side exceeds an allowable voltage deviation range.

A method for calculating the voltage deviation value of the transformer is: a difference between a calculated voltage at the high-voltage side of the transformer and a system nominal voltage is divided by the system nominal voltage and is multiplied by 100%, that is, (a calculated voltage at the high-voltage side of the transformer-a system nominal voltage)/the system nominal voltage*100%.

If a three-phase load unbalance rate at the low-voltage side exceeds a calibrated distribution load unbalance rate by 15%, it is determined that the three-phase load unbalance rate at the low-voltage side is greater than a calibration required value.

Embodiment 3

The technical problem to be solved by the embodiment lies in: for the existing oil-immersed distribution transformer, when operation parameters of the transformer are calculated, voltage and current parameters on the high-voltage or low-voltage side are required to be collected at the same time. An expensive voltage transformer is used necessarily on the 10 kV high-voltage side of the existing transformer, but the existing high-voltage transformer is immature in application and is insufficient in operation stability, and therefore defects exist in actual use. Moreover, the existing apparatus for monitoring the oil-immersed distribution transformer cannot completely master the operation state of the transformer.

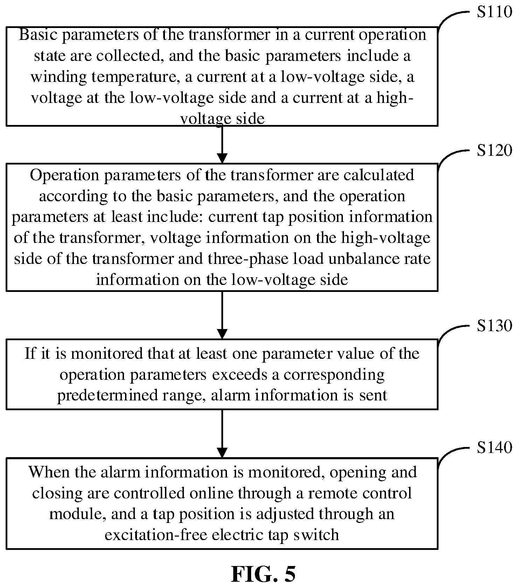

As illustrated in FIG. 5, a method for monitoring a transformer is provided by the embodiment, and may include the following operations.

At S110: basic parameters of the transformer in a current operation state are collected, and the basic parameters include a winding temperature, a current at a low-voltage side, a voltage at the low-voltage side and a current at a high-voltage side.

At S120: operation parameters of the transformer are calculated according to the basic parameters, and the operation parameters at least include: current tap position information of the transformer, voltage information on the high-voltage side of the transformer and three-phase load unbalance rate information on the low-voltage side.

At S130: if it is monitored that at least one parameter value of the operation parameters exceeds a corresponding predetermined range, alarm information is sent.

At S140: when the alarm information is monitored, opening and closing are controlled online through a remote control module, and a tap position is adjusted through an excitation-free electric tap switch.

By calculating the voltage information on the high-voltage side, the use of a high-voltage transformer is avoided, the cost and the monitoring qualification rate of the device are guaranteed to the greatest extent while the monitoring precision is guaranteed, and an alarm may be sent timely in case of abnormity and failure of the device to prevent the loss caused by shutdown of the transformer.

Embodiment 4

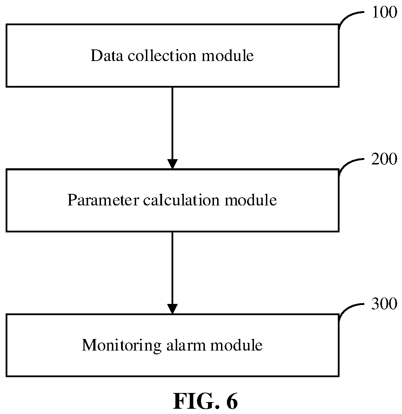

As illustrated in FIG. 6, an apparatus for monitoring a transformer is provided by the embodiment, and may include: a data collection module 100, a parameter calculation module 200, and a monitoring alarm module 300.

The data collection module 100 is configured to collect basic parameters of the transformer in a current operation state, the basic parameters including a winding temperature, a current at a low-voltage side, a voltage at the low-voltage side and a current at a high-voltage side.

The parameter calculation module 200 is configured to calculate operation parameters of the transformer according to the basic parameters, the operation parameters at least including: current tap position information of the transformer, voltage information on the high-voltage side of the transformer and three-phase load unbalance rate information on the low-voltage side.

The monitoring alarm module 300 is configured to send alarm information if monitoring that at least one parameter value of the operation parameters exceeds a corresponding predetermined range.

By calculating the voltage information on the high-voltage side, the use of a high-voltage transformer is avoided, the cost and the monitoring qualification rate of the device are guaranteed to the greatest extent while the monitoring precision is guaranteed, and an alarm may be sent timely in case of abnormity and failure of the device to prevent the loss caused by shutdown of the transformer.

Embodiment 5

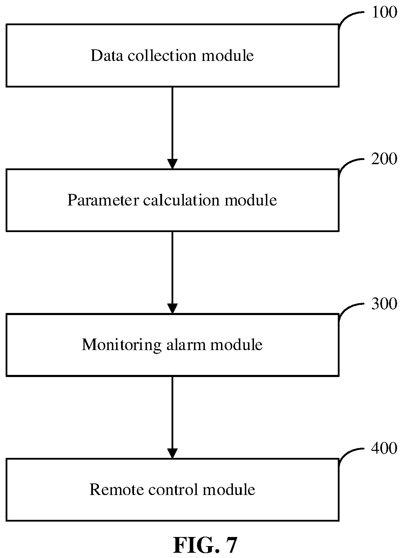

As illustrated in FIG. 7, an apparatus for monitoring a transformer is provided by the embodiment, and may include: a data collection module 100, a parameter calculation module 200, a monitoring alarm module 300, and a remote control module 400.

The data collection module 100 is configured to collect basic parameters of the transformer in a current operation state, the basic parameters including a winding temperature, a current at a low-voltage side, a voltage at the low-voltage side and a current at a high-voltage side.

The parameter calculation module 200 is configured to calculate operation parameters of the transformer according to the basic parameters, the operation parameters at least including: current tap position information of the transformer, voltage information on the high-voltage side of the transformer and three-phase load unbalance rate information on the low-voltage side.

The monitoring alarm module 300 is configured to send alarm information if monitoring that at least one parameter value of the operation parameters exceeds a corresponding predetermined range.

The remote control module 400 is configured to control opening and closing online when monitoring the alarm information, and adjust a tap position through an excitation-free electric tap switch.

By calculating the voltage information on the high-voltage side, the use of a high-voltage transformer is avoided, the cost and the monitoring qualification rate of the device are guaranteed to the greatest extent while the monitoring precision is guaranteed, and an alarm may be sent timely in case of abnormity and failure of the device to prevent the loss caused by shutdown of the transformer.

An embodiment of the application further provides an apparatus for monitoring a transformer, which may include: a processor and a memory configured to store a computer program capable of running on the processor; and the processor executes, when configured to run the computer program, the steps of the method for monitoring the transformer.

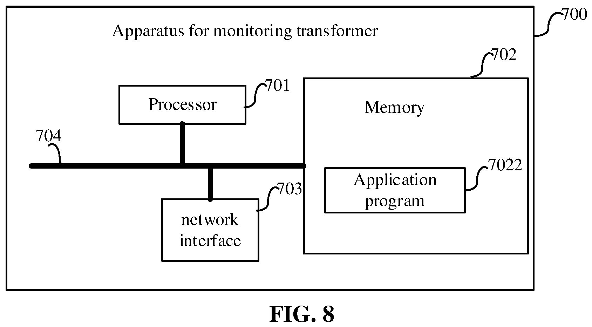

FIG. 8 is a structure diagram of a hardware composition of an apparatus for monitoring a transformer provided by an embodiment of the application. The apparatus 700 for monitoring the transformer may include: at least one processor 701, a memory 702 and at least one network interface 703. Each assembly in the apparatus 700 for monitoring the transformer is coupled together via a bus system 704. It may be understood that the bus system 704 is configured to implement connection and communication among these assemblies. In addition to a data bus, the bus system 704 may further include a power bus, a control bus and a state signal bus. For ease of clarity, each bus in FIG. 8 is labeled as the bus system 704.

It may be understood that the memory 702 may be a volatile memory or a nonvolatile memory, and may also include both the volatile memory and the nonvolatile memory. The nonvolatile memory may be a read only memory (ROM), a programmable read-only memory (PROM), an erasable programmable read-only memory (EPROM), an electrically erasable programmable read-only memory (EEPROM), a ferromagnetic random access memory (FRAM), a flash memory, a magnetic surface memory, an optical disc or a compact disc read-only memory (CD-ROM); and the magnetic surface memory may be a magnetic disk memory or a magnetic tape memory. The volatile memory may be a random access memory (RAM), and serves as an external high-speed cache. Through illustrative but not restrictive description, many forms of RAMs may be available, for example, a static random access memory (SRAM), a synchronous static random access memory (SSRAM), a dynamic random access memory (DRAM), a synchronous dynamic random access memory (SDRAM), a double data rate synchronous dynamic random access memory (DDRSDRAM), an enhanced synchronous dynamic random access memory (ESDRAM), a synchronous link dynamic random access memory (SLDRAM), and a direct rambus random access memory (DRRAM). The memory 702 described in the embodiment of the application includes, but is not limited to, these and any other appropriate types of memories.

In the embodiment of the application, the memory 702 is configured to store various types of data to support the operation of the apparatus 700 for monitoring the transformer. Examples of such data include: any computer program operated on the apparatus 700 for monitoring the transformer, such as an application program 7022. The program for implementing the method in the embodiment of the application may be included in the application program 7022.

The method disclosed in the above embodiment of the application may be applied to the processor 701, or may be implemented by the processor 701. The processor 701 may be an integrated circuit chip, and has a signal processing capability. During implementation, each step of the method may be completed by means of an instruction in a form of an integrated logic circuit of hardware in the processor 701 or software. The processor 701 may be a universal processor, a digital signal processor (DSP), or another programmable logic device, separate gate or transistor logic device, separate hardware component and the like. The processor 701 may implement or execute each method, step or logic block diagram disclosed in the embodiment of the application. The universal processor may be a microprocessor, or any conventional processor, etc. The step of the method disclosed in combination with the embodiments of the application may be directly embodied as a hardware decoding processor for execution and completion, or a combination of hardware and software modules in the decoding processor for execution and completion. The software module may be located in a storage medium. The storage medium is in the memory 702. The processor 701 reads information in the memory 702, and completes the step of the above method in combination with hardware.

In an exemplary embodiment, the apparatus 700 for monitoring the transformer may be implemented by one or more of an application specific integrated circuit (ASIC), a digital signal processor (DSP), a programmable logic device (PLD), a complex programmable logic device (CPLD), a field programmable gate array (FPGA), a universal processor, a controller, a micro controller unit (MCU), a micro processor unit (MPU), or other electronic components to execute the above method.

An embodiment of the application further provides a storage medium, which is configured to store a computer program; and the computer program causes a computer to execute corresponding procedures in the method for monitoring the transformer in the embodiments of the application. For clarity, the details are not elaborated herein.

**Claims**

1. A method for monitoring a transformer, comprising:

collecting basic parameters of the transformer in a current operation state, the basic parameters comprising a winding temperature, a current at a low-voltage side, a voltage at the low-voltage side and a current at a high-voltage side;

calculating operation parameters of the transformer according to the basic parameters, the operation parameters at least comprising: current tap position information of the transformer, voltage information on the high-voltage side of the transformer and three-phase load unbalance rate information on the low-voltage side; and

sending alarm information in response to monitoring that at least one parameter value of the operation parameters exceeds a corresponding predetermined range;

wherein the step of calculating the operation parameters of the transformer according to the basic parameters comprises:

calculating a dynamic phase splitting line impedance of the transformer according to a phase splitting positive sequence line impedance at a premeasured winding temperature $\tau_0$ of the transformer, and an average winding temperature $\tau_1$;

wherein the phase splitting positive sequence line impedance at the premeasured winding temperature $\tau_0$ of the transformer is: $\left(\overline{Z_{1A}} + \overline{Z'_{2A}}\right) = R_A + jX_A$, $\left(\overline{Z_{1B}} + \overline{Z'_{2B}}\right) = R_B + jX_B$ and $\left(\overline{Z_{1C}} + \overline{Z'_{2C}}\right) = R_C + jX_C$;

wherein a coefficient for the average winding temperature $\tau_1$ is:

$k_t = (235 + \tau_1)/(235 + \tau_0)$, where a value of the $k_t$ is a temperature coefficient;
a dynamic phase splitting positive sequence line impedance at the average winding temperature $\tau_1$ is:

$$\left(\overline{Z_{1A}} + \overline{Z'_{2A}}\right) = k_t \times R_A + jX_A \quad, \quad \left(\overline{Z_{1B}} + \overline{Z'_{2B}}\right) = k_t \times R_B + jX_B \quad,$$

and

$$\left(\overline{Z_{1C}} + \overline{Z'_{2C}}\right) = k_t \times R_C + jX_C \quad,$$

where, the $\left(\overline{Z_{1A}} + \overline{Z'_{2A}}\right)$ is converted to a positive sequence line impedance at the high-voltage side; a negative sequence line impedance of the transformer is equal to the positive sequence line impedance of the transformer; a zero sequence impedance of the transformer is a measured value; in case of Dy connection, it is $\left(\overline{Z_{1A}} // \overline{Z_m^0} + \overline{Z'_{2A}}\right)$; and in case of Yy connection, it is $\left(\overline{Z_m^0} + \overline{Z'_{2A}}\right)$;

through the voltage at the low-voltage side of the transformer and the current at the low-voltage side, determining a three-phase positive sequence voltage, a three-phase negative sequence voltage and a three-phase zero sequence voltage at the high-voltage side, as well as a three-phase positive sequence current, a three-phase negative sequence current and a three-phase zero sequence current at the high-voltage side in terms of a symmetrical component method, wherein in case of an A-phase circuit:

wherein the three-phase positive sequence voltage converted from the low-voltage side to the high-voltage side is: $-\overline{U}_a^{+'} = k_n \times \left(-\overline{U}_a^+\right)$; the three-phase negative sequence voltage converted from the low-voltage side to the high-voltage side is: $-\overline{U}_a^{-'} = k_n \times \left(-\overline{U}_a^-\right)$; and the three-phase zero sequence voltage converted from the low-voltage side to the high-voltage side is:

$-\overline{U}_a^{0'} = k_n \times \left(-\overline{U}_a^0\right)$, where, the $k_n$ is a theoretical variation ratio at an n tap position, and the

$-\overline{U}_a^+$, the $-\overline{U}_a^{+'}$ and the $-\overline{U}_a^0$ are positive, negative and zero sequence voltages at the low-voltage side; and

wherein the positive sequence current at the high-voltage side is: $\overline{I}_A^+ = -\overline{I}_a^+$; the negative sequence current at the high-voltage side is: $\overline{I}_A^- = -\overline{I}_a^-$; and the zero sequence current at the high-voltage side is: $\overline{I}_A^0 = -\overline{I}_a^0$, where, the $-\overline{I}_a^+$, the $-\overline{I}_a^-$ and the $-\overline{I}_a^0$ are currents converted from the low-voltage side to the high-voltage side; and

calculating the voltage at the high-voltage side according to the dynamic phase splitting line impedance of the transformer as well as the three-phase positive sequence voltage/current, negative sequence voltage/current and zero sequence voltage/current at the low-voltage side, wherein in case of the A-phase circuit, $\overline{U}_A = \overline{U}_A^+ + \overline{U}_A^- + \overline{U}_A^0$ , where,

$$\overline{U}_A^+ = -\overline{U}_a^{+'} + \overline{I}_A^+ \times \left( \overline{Z_{1A}} + \overline{Z_{2A}'} \right) , \quad \overline{U}_A^- = -\overline{U}_a^{-'} + \overline{I}_A^- \times \left( \overline{Z_{1A}} + \overline{Z_{2A}'} \right) , \text{ and } \overline{U}_A^0 = \overline{I}_A^0 \times \overline{Z_{1A}} .$$

2. The method for monitoring the transformer of claim 1, wherein the step of calculating the operation parameters of the transformer according to the basic parameters comprises:

   calculating a tap changer position according to the current at the high-voltage side, the current at the low-voltage side and a known theoretical variation ratio $k_n$; and

   determining that the tap changer position is n in response to meeting $\left| \dfrac{I_1}{I_2} - k_n \right| / k_n < 1.25\%$ .

3. The method for monitoring the transformer of claim 1, wherein the step of calculating the operation parameters of the transformer according to the basic parameters comprises:
   causing a three-phase load unbalance rate at the low-voltage side to be a ratio of a difference between a maximum phase load and a minimum phase load to the maximum phase load.

4. The method for monitoring the transformer of claim 1, wherein the step of monitoring that the current tap position information of the transformer exceeds the corresponding predetermined range comprises:
   calculating a ratio k of an average three-phase voltage value of the transformer to a rated voltage at the low-voltage side, and in case of $(K-K_n)/K_n > 2.5\%$, determining that a tap position of the transformer needs to be adjusted, and giving a tap position to be adjusted.

5. The method for monitoring the transformer of claim 1, wherein the step of monitoring that the voltage information on the high-voltage side of the transformer exceeds the corresponding predetermined range comprises:
   calculating a voltage deviation value of the transformer; and in response to the voltage deviation value of the transformer exceeding 7%, determining that the voltage at the high-voltage side exceeds an allowable voltage deviation range.

6. The method for monitoring the transformer of claim 5, wherein the step of calculating the voltage deviation value of the transformer comprises: a ratio of a difference between a calculated voltage at the high-voltage side of the transformer and a system nominal voltage to the system nominal voltage.

7. The method for monitoring the transformer of claim 3, wherein the step of monitoring that the three-phase load unbalance rate information on the low-voltage side exceeds the corresponding predetermined range comprises:
   in response to a three-phase load unbalance rate at the low-voltage side exceeding a calibrated distribution load unbalance rate by 15%, determining that the three-phase load unbalance rate at the low-voltage side is greater than a calibration required value.

8. The method for monitoring the transformer of claim 1, further comprising:
   in response to monitoring the alarm information, controlling opening and closing online through a remote control module, and adjusting a tap position through an excitation-free electric tap switch.

9. A storage medium, storing an executable program, wherein the executable program implements, when executed by a processor, the method for monitoring the transformer of any one of claims 1 to 8.

10. An apparatus for monitoring a transformer, comprising a processor and a memory configured to store a computer program capable of running on the processor, wherein
    the processor executes, when configured to run the computer program, the steps of the method for monitoring the transformer of any one of claims 1 to 8.

**Patentansprüche**

1.  Verfahren zur Überwachung eines Transformators, umfassend:

    Sammeln von grundlegenden Parametern des Transformators in einem aktuellen Betriebszustand, wobei die grundlegenden Parameter eine Wicklungstemperatur, einen Strom an einer Niederspannungsseite, eine Spannung an der Niederspannungsseite und einen Strom an einer Hochspannungsseite umfassen;
    Berechnen von Betriebsparametern des Transformators gemäß den grundlegenden Parametern, wobei die Betriebsparameter mindestens umfassen: Stromabgriffspositionsinformationen des Transformators, Spannungsinformationen auf der Hochspannungsseite des Transformators und Dreiphasenschieflastrateninformationen auf der Niederspannungsseite; und
    Senden von Alarminformationen als Reaktion auf ein Überwachen, dass mindestens ein Parameterwert der Betriebsparameter einen entsprechenden vorherbestimmten Bereich übersteigt;
    wobei der Schritt des Berechnens der Betriebsparameter des Transformators gemäß den grundlegenden Parametern umfasst:

    Berechnen einer dynamischen Phasentrennleitungsimpedanz des Transformators gemäß einer Phasentrennungspositivsequenzleitungsimpedanz bei einer vorher gemessenen Wicklungstemperatur $\tau_0$ des Transformators und einer durchschnittlichen Wicklungstemperatur $\tau_1$;
    wobei die Phasentrennungspositivsequenzleitungsimpedanz bei der vorher gemessenen Wicklungstemperatur $\tau_0$ des Transformators ist: $\left(\overline{Z_{1A}} + \overline{Z'_{2A}}\right) = R_A + jX_A$   $\left(\overline{Z_{1B}} + \overline{Z'_{2B}}\right) = R_B + jX_B$   und

    $$\left(\overline{Z_{1C}} + \overline{Z'_{2C}}\right) = R_C + jX_C$$ ;

    wobei ein Koeffizient für die durchschnittliche Wicklungstemperatur $\tau_1$ ist:

    $k_t = (235 + \tau_1)/(235 + \tau_0)$ worin ein Wert des $k_t$ ein Temperaturkoeffizient ist;
    wobei eine dynamische Phasentrennungspositivsequenzleitungsimpedanz bei der durchschnittlichen Wicklungstemperatur $\tau_1$ ist:

    $$\left(\overline{Z_{1A}} + \overline{Z'_{2A}}\right) = k_t \times R_A + jX_A \quad , \quad \left(\overline{Z_{1B}} + \overline{Z'_{2B}}\right) = k_t \times R_B + jX_B$$

    und

    $$\left(\overline{Z_{1C}} + \overline{Z'_{2C}}\right) = k_t \times R_C + jX_C$$

    worin die $\left(\overline{Z_{1A}} + \overline{Z'_{2A}}\right)$ in eine Positivsequenzleitungsimpedanz bei der Hochspannungsseite umgewandelt wird; eine Negativsequenzleitungsimpedanz des Transformators gleich der Positivsequenzleitungsimdepanz des Transformators ist; eine Nullsequenzimpedanz des Transformators ein Messwert ist; sie im Fall einer Dy-Verbindung $\left(\overline{Z_{1A}} // \overline{Z_m^0} + \overline{Z'_{2A}}\right)$ st und sie im Fall einer Yy-Vrbindung $\left(\overline{Z_m^0} + \overline{Z'_{2A}}\right)$ ist;
    durch die Spannung an der Niederspannungsseite des Transformators und den Strom an der Niederspannungsseite Bestimmen einer Dreiphasenpositivsequenzspannung, einer Dreiphasennegativsequenzspannung und einer Dreiphasennullsequenzspannung an der Hochspannungsseite sowie eines Dreiphasenpositivsequenzstroms, eines Dreiphasennegativsequenzstroms und eines Dreiphasennullsequenzstroms an der Hochspannungsseite bezüglich eines symmetrischen Komponentenverfahrens, wobei im Fall einer A-Phasenschaltung:
wobei die Dreiphasenpositivsequenzspannung, die von der Niederspannungsseite zu der Hochspannungsseite umgewandelt wird, ist: $-\overline{U}_a^{+'} = k_n \times \left(-\overline{U}_a^+\right)$ die Dreiphasennegativsequenzspannung, die von der Niederspannungsseite zu der Hochspannungsseite umgewandelt wird, ist:

$-\overline{U}_a^{-'} = k_n \times \left(-\overline{U}_a^-\right)$ ; und die Dreiphasennullsequenzspannung, die von der Niederspannungsseite zu der Hochspannungsseite umgewandelt wird, ist: $-\overline{U}_a^{0'} = k_n \times \left(-\overline{U}_a^0\right)$ worin das $k_n$ ein

theoretisches Variationsverhältnis an einer n Abgriffsposition ist und die $-\overline{U}_a^+$ die $-\overline{U}_a^{+'}$ und die

$-\overline{U}_a^0$ die Positiv-, die Negativ- und die Nullsequenzspannung an der Niederspannungsseite sind; und

wobei der Positivsequenzstrom an der Hochspannungsseite ist: $\overline{I_A^+} = -\overline{I_a^+}$ ; der Negativsequenzstrom an der Hochspannungsseite ist: $\overline{I_A^-} = -\overline{I_a^-}$ ; und der Nullsequenzstrom an der Hochspannungsseite ist: $\overline{I_A^0} = -\overline{I_a^0}$ , worin der $-\overline{I_a^{+'}}$ der $-\overline{I_a^-}$ und der $-\overline{I_a^0}$ Ströme sind, die von der
Niederspannungsseite zu der Hochspannungsseite umgewandelt werden; und
Berechnen der Spannung an der Hochspannungsseite gemäß der dynamischen Phasentrennleitungsimpedanz des Transformators sowie der Dreiphasenpositivsequenzspannung/des Dreiphasenpositivsequenzstroms, der Negativsequenzspannung/des Negativsequenzstroms und der Nullsequenzspannung/des Nullsequenzstroms an der Niederspannungsseite, wobei in dem Fall einer A-Phasenschaltung $\overline{U}_A = \overline{U}_A^+ + \overline{U}_A^- + \overline{U}_A^0$ worin

$$\overline{U}_A^+ = -\overline{U}_a^{+'} + \overline{I}_A^+ \times \left(\overline{Z_{1A}} + \overline{Z_{2A}'}\right) , \quad \overline{U}_A^- = -\overline{U}_a^{-'} + \overline{I}_A^- \times \left(\overline{Z_{1A}} + \overline{Z_{2A}'}\right) .$$

und

$$\overline{U}_A^0 = \overline{I}_A^0 \times \overline{Z_{1A}} .$$

2. Verfahren zur Überwachung des Transformators nach Anspruch 1, wobei der Schritt des Berechnens der Betriebsparameter des Transformators gemäß den grundlegenden Parametern umfasst:

   Berechnen einer Abgriffswechslerposition gemäß dem Strom an der Hochspannungsseite, dem Strom an der
   Niederspannungsseite und einem bekannten theoretischen Variationsverhältnis $k_n$ und

   Bestimmen, dass die Abgriffswechslerposition n ist als Reaktion auf Erfüllen von $\left|\dfrac{I_1}{I_2} - k_n\right| / k_n < 1.25\%$ .

3. Verfahren zur Überwachung des Transformators nach Anspruch 1, wobei der Schritt des Berechnens der Betriebsparameter des Transformators gemäß den grundlegenden Parametern umfasst:
   Bewirken, dass eine Dreiphasenschieflastrate an der Niederspannungsseite ein Verhältnis einer Differenz zwischen
   einer maximalen Phasenlast und einer minimalen Phasenlast zu der maximalen Phasenlast ist.

4. Verfahren zur Überwachung des Transformators nach Anspruch 1, wobei der Schritt des Überwachens, dass die
   Stromabgriffspositionsinformationen des Transformators den entsprechenden vorherbestimmten Bereich übersteigen, umfasst:
Berechnen eines Verhältnisses k eines durchschnittlichen Dreiphasenspannungswerts des Transformators zu einer Nennspannung an der Niederspannungsseite und in dem Fall von $(K-K_n)/K_n > 2.5\%$ Bestimmen, dass eine Abgriffsposition des Transformators justiert werden muss, und Ergeben, dass eine Abgriffsposition justiert wird.

5. Verfahren zur Überwachung des Transformators nach Anspruch 1, wobei der Schritt des Überwachens, dass die Spannungsinformationen auf der Hochspannungsseite des Transformators den entsprechenden vorherbestimmten Bereich übersteigen, umfasst:
Berechnen eines Spannungsabweichungswerts des Transformators und als Reaktion darauf, dass der Spannungsabweichungswert des Transformators 7% übersteigt, Bestimmen, dass die Spannung an der Hochspannungsseite einen zulässigen Spannungsabweichungsbereich übersteigt.

6. Verfahren zur Überwachung des Transformators nach Anspruch 5, wobei der Schritt des Berechnens des Spannungsabweichungswerts des Transformators umfasst: ein Verhältnis einer Differenz zwischen einer berechneten Spannung an der Hochspannungsseite des Transformators und einer Systemnennspannung zu der Systemnennspannung.

7. Verfahren zur Überwachung des Transformators nach Anspruch 3, wobei der Schritt des Überwachens, dass die Dreiphasenschieflastrateninformationen auf der Niederspannungsseite den entsprechenden vorherbestimmten Bereich übersteigen, umfasst:
als Reaktion darauf, dass eine Dreiphasenschieflastrate an der Niederspannungsseite eine kalibrierte Verteilungsschieflastrate um 15% übersteigt, Bestimmen, dass die Dreiphasenschieflastrate an der Niederspannungsseite höher als ein kalibrationserforderlicher Wert ist.

8. Verfahren zur Überwachung des Transformators nach Anspruch 1, weiterhin umfassend:
als Reaktion auf das Überwachen der Alarminformationen Steuern eines Online-Öffnens und -Schließens durch ein Fernsteuermodul und Justieren einer Abgriffsposition durch einen anregungsfreien elektrischen Abgriffsschalter.

9. Speichermedium, das ein ausführbares Programm speichert, wobei das ausführbare Programm bei Ausführung durch einen Prozessor das Verfahren zur Überwachung des Transformators nach einem der Ansprüche 1 bis 8 implementiert.

10. Vorrichtung zur Überwachung eines Transformators, umfassend einen Prozessor und einen Speicher, der dazu konfiguriert ist, ein Computerprogramm zu speichern, dass auf dem Prozessor ausgeführt werden kann, wobei der Prozessor bei Konfiguration zum Ausführen des Computerprogramms die Schritte des Verfahrens zur Überwachung des Transformators nach einem der Ansprüche 1 bis 8 ausführt.

**Revendications**

1. Procédé de surveillance d'un transformateur, comprenant de:

collecter des paramètres de base du transformateur dans un état de fonctionnement actuel, les paramètres de base comprenant une température d'enroulement, un courant du côté basse tension, une tension du côté basse tension et un courant du côté haute tension;
calculer des paramètres de fonctionnement du transformateur en fonction des paramètres de base, les paramètres de fonctionnement comprenant au moins: des informations de position de prise de courant du transformateur, des informations de tension du côté haute tension du transformateur et des informations de taux de déséquilibre de charge triphasée du côté basse tension; et
envoyer des informations d'alarme en réponse à une surveillance indiquant qu'au moins une valeur de paramètre des paramètres de fonctionnement dépasse une plage prédéterminée correspondante;
dans lequel l'étape de calcul des paramètres de fonctionnement du transformateur en fonction des paramètres de base comprend de:

calculer une impédance de ligne de déphasage dynamique du transformateur selon une impédance de ligne directe de déphasage à une température d'enroulement prémesurée $\tau_0$ du transformateur, et une température d'enroulement moyenne $\tau_1$;

dans lequel l'impédance de ligne directe de déphasage à la température d'enroulement prémesurée $\tau_0$ du

transformateur est: $\left(\overline{Z_{1A}} + \overline{Z'_{2A}}\right) = R_A + jX_A$ , $\left(\overline{Z_{1B}} + \overline{Z'_{2B}}\right) = R_B + jX_B$ et $\left(\overline{Z_{1C}} + \overline{Z'_{2C}}\right) = R_C + jX_C$ ;

dans lequel un coefficient pour la température d'enroulement moyenne $\tau_1$ est: $k_t = (235+\tau_1)/(235+\tau_0)$, où une valeur de $k_t$ est un coefficient de température;

une impédance de ligne directe de déphasage dynamique à la température d'enroulement moyenne $\tau_1$ est:

$$\left(\overline{Z_{1A}} + \overline{Z'_{2A}}\right) = k_t \times R_A + jX_A \quad , \quad \left(\overline{Z_{1B}} + \overline{Z'_{2B}}\right) = k_t \times R_B + jX_B \quad ,$$

et

$$\left(\overline{Z_{1C}} + \overline{Z'_{2C}}\right) = k_t \times R_C + jX_C \quad ,$$

où, $\left(\overline{Z_{1A}} + \overline{Z'_{2A}}\right)$ est convertie en une impédance de ligne directe du côté haute tension; une impédance de ligne inverse du transformateur est égale à l'impédance de ligne directe du transformateur; une impédance homopolaire du transformateur est une valeur mesurée; dans le cas d'une connexion Dy, c'est

$\left(\overline{Z_{1A}} // \overline{Z^0_m} + \overline{Z'_{2A}}\right)$ ; et dans le cas d'une connexion Yy, c'est $\left(\overline{Z^0_m} + \overline{Z'_{2A}}\right)$ ;

par l'intermédiaire de la tension du côté basse tension du transformateur et du courant du côté basse tension, déterminer une tension directe triphasée, une tension inverse triphasée et une tension homopolaire triphasée du côté haute tension, ainsi qu'un courant direct triphasé, un courant inverse triphasé et un courant homopolaire triphasé du côté haute tension en termes de méthode de composantes symétriques, dans lequel, dans le cas d'un circuit de phase A:

dans lequel la tension directe triphasée convertie du côté basse tension au côté haute tension est: $-\overline{U}^{+'}_a = k_n \times \left(-\overline{U}^+_a\right)$ ; la tension inverse triphasée convertie du côté basse tension au côté haute tension est: $-\overline{U}^{-'}_a = k_n \times \left(-\overline{U}^-_a\right)$ ; et la tension homopolaire triphasée convertie du côté basse tension au côté haute tension est: $-\overline{U}^{0'}_a = k_n \times \left(-\overline{U}^0_a\right)$ , où $k_n$ est un rapport de variation théorique à une position de prise n, et $-\overline{U}^+_a$ , $-\overline{U}^{+'}_a$ et $-\overline{U}^0_a$ sont des tensions directe, inverse et homopolaire du côté basse tension; et

dans lequel le courant direct du côté haute tension est: $\overline{I}^+_A = -\overline{I}^+_a$ ; le courant inverse du côté haute tension est: $\overline{I}^-_A = -\overline{I}^-_a$ ; et le courant homopolaire du côté haute tension est: $\overline{I}^0_A = -\overline{I}^0_a$

, où, $-\overline{I}^+_a$ , $-\overline{I}^-_a$ et $-\overline{I}^0_a$ sont des courants convertis du côté basse tension au côté haute tension; et

calculer la tension du côté haute tension en fonction de l'impédance de ligne de déphasage dynamique du transformateur ainsi que de la tension/courant direct triphasé, de la tension/courant inverse et de la tension/courant homopolaire du côté basse tension, dans lequel, dans le cas d'un circuit de phase A

$$\overline{U}_A = \overline{U}_A^+ + \overline{U}_A^- + \overline{U}_A^0 \,,$$

où

$$\overline{U}_A^+ = -\overline{U}_a^{+'} + \overline{I}_A^+ \times \left( \overline{Z_{1A}} + \overline{Z'_{2A}} \right), \quad \overline{U}_A^- = -\overline{U}_a^{-'} + \overline{I}_A^- \times \left( \overline{Z_{1A}} + \overline{Z'_{2A}} \right),$$

et

$$\overline{U}_A^0 = \overline{I}_A^0 \times \overline{Z_{1A}} .$$

**2.** Procédé de surveillance du transformateur selon la revendication 1, dans lequel l'étape de calcul des paramètres de fonctionnement du transformateur en fonction des paramètres de base comprend de:

calculer une position de changeur de prise en fonction du courant du côté haute tension, du courant du côté basse tension et d'un rapport de variation théorique connu $k_n$; et

déterminer que la position du changeur de prise est n en réponse à la satisfaction de $\left| \dfrac{I_1}{I_2} - k_n \right| / k_n < 1.25\%$ .

**3.** Procédé de surveillance du transformateur selon la revendication 1, dans lequel l'étape de calcul des paramètres de fonctionnement du transformateur en fonction des paramètres de base comprend de:
faire en sorte qu'un taux de déséquilibre de charge triphasée du côté basse tension soit un rapport d'une différence entre une charge de phase maximale et une charge de phase minimale à la charge de phase maximale.

**4.** Procédé de surveillance du transformateur selon la revendication 1, dans lequel l'étape de surveillance du fait que les informations de position de prise de courant du transformateur dépassent la plage prédéterminée correspondante comprend de:
calculer un rapport k d'une valeur de tension triphasée moyenne du transformateur à une tension nominale du côté basse tension, et dans le cas de $(K-K_n)/K_n > 2.5\%$, déterminer qu'une position de prise du transformateur doit être ajustée, et donner une position de prise à ajuster.

**5.** Procédé de surveillance du transformateur selon la revendication 1, dans lequel l'étape de surveillance du fait que les informations de tension du côté haute tension du transformateur dépassent la plage prédéterminée correspondante comprend de:
calculer une valeur d'écart de tension du transformateur; et en réponse au fait que la valeur d'écart de tension du transformateur dépasse 7%, déterminer que la tension du côté haute tension dépasse une plage d'écart de tension admissible.

**6.** Procédé de surveillance du transformateur selon la revendication 5, dans lequel l'étape de calcul de la valeur d'écart de tension du transformateur comprend: un rapport d'une différence entre une tension calculée du côté haute tension du transformateur et une tension nominale du système à la tension nominale du système.

**7.** Procédé de surveillance du transformateur selon la revendication 3, dans lequel l'étape de surveillance du fait que les informations de taux de déséquilibre de charge triphasée du côté basse tension dépassent la plage prédéterminée correspondante comprend de:

en réponse au fait qu'un taux de déséquilibre de charge triphasée du côté basse tension dépasse de 15% un taux de déséquilibre de charge de distribution calibré, déterminer que le taux de déséquilibre de charge triphasée du côté basse tension est supérieur à une valeur requise de calibrage.

8. Procédé de surveillance du transformateur selon la revendication 1, comprenant en outre de:
   en réponse à la surveillance des informations d'alarme, commander l'ouverture et la fermeture en ligne par le biais d'un module de commande à distance, et ajuster une position de prise par le biais d'un commutateur de prise électrique sans excitation.

9. Support de stockage, stockant un programme exécutable, dans lequel le programme exécutable met en œuvre, lorsqu'il est exécuté par un processeur, le procédé de surveillance du transformateur de l'une quelconque des revendications 1 à 8.

10. Appareil pour surveiller un transformateur, comprenant un processeur et une mémoire configurée pour stocker un programme informatique capable de fonctionner sur le processeur, dans lequel
    le processeur exécute, lorsqu'il est configuré pour exécuter le programme informatique, les étapes du procédé de surveillance du transformateur de l'une quelconque des revendications 1 à 8.

Basic parameters of the transformer in a current operation state are collected, and the basic parameters include a winding temperature, a current at a low-voltage side, a voltage at the low-voltage side and a current at a high-voltage side — S110

Operation parameters of the transformer are calculated according to the basic parameters, and the operation parameters at least include: current tap position information of the transformer, voltage information on the high-voltage side of the transformer and three-phase load unbalance rate information on the low-voltage side — S120

If it is monitored that at least one parameter value of the operation parameters exceeds a corresponding predetermined range, alarm information is sent — S130

**FIG. 1**

**FIG. 2**

$$\overline{Z_{1A}} \qquad \overline{Z'_{2A}}$$

$A$     $a$

$$\overline{U_A} \qquad \overline{I_A} = -\overline{I_a} \qquad -\overline{U'_a}$$

$X$     $x$

**FIG. 3**

**FIG. 4**

Basic parameters of the transformer in a current operation
state are collected, and the basic parameters include a
winding temperature, a current at a low-voltage side, a
voltage at the low-voltage side and a current at a high-
voltage side

S110

Operation parameters of the transformer are calculated
according to the basic parameters, and the operation
parameters at least include: current tap position information
of the transformer, voltage information on the high-voltage
side of the transformer and three-phase load unbalance rate
information on the low-voltage side

S120

If it is monitored that at least one parameter value of the
operation parameters exceeds a corresponding
predetermined range, alarm information is sent

S130

When the alarm information is monitored, opening and
closing are controlled online through a remote control
module, and a tap position is adjusted through an
excitation-free electric tap switch

S140

## FIG. 5

100

Data collection module

200

Parameter calculation module

300

Monitoring alarm module

**FIG. 6**

FIG. 7

Apparatus for monitoring transformer

700

Processor
701

Memory
702

704

network
interface
703

Application
program
7022

**FIG. 8**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201910565853
- EP 2730929 A1
- WO 2008057810 A2
- US 2017030958 A1